# EUROPEAN PATENT APPLICATION

(11) **EP 4 567 870 A1**
(43) Date of publication of application: **11.06.2025**
(21) Application number: 23215155.5
(22) Date of filing: 08.12.2023
(51) Int. Cl.: H01L 21/67

(54) **ELECTRONIC COMPONENT TRANSFER BY LEVITATION**

(71) Applicant: Nexperia B.V., 6534 AB Nijmegen (NL)
(72) Inventor: Conte Capodacqua, Filippo Maria, Delft (NL); Tichem, Marcel, Delft (NL); Van der Veen, Gijs, Nijmegen (NL)
(74) Representative: Pjanovic, Ilija

(57) **Abstract**

Aspects of the present disclosure relate to a system for transferring an electronic component. Further aspects of the present disclosure relate to a method for transferring an electronic component.

According to an aspect of the present disclosure, the system comprises a carrier having a first side, a droplet dispensing unit for dispensing a droplet of liquid on the first side of the carrier, and a separating unit for releasing an electronic component from a donor substrate and for allowing the electronic component to be held by the droplet of liquid on the first side of the carrier. The system further comprises an optical source for emitting a pulse of light through the carrier towards an interface between the droplet and the carrier to locally vaporize the droplet thereby causing a jet to be formed from the droplet that on one end holds the electronic component and that subsequently breaks to thereby release the electronic component onto a target substrate.

## Description

### FIELD

Aspects of the present disclosure relate to a system for transporting an electronic component. Further aspects of the present disclosure relate to a method for transporting an electronic component. Aspects of the present disclosure also relate to a system and method for transferring an electronic component.

### BACKGROUND

In semiconductor assembly, electronic components such as semiconductor dies often need to be transported between a source unit and a target unit. For example, the source unit may comprise a diced semiconductor wafer and the target unit may comprise a printed circuit board on which one or more of the dies on the diced semiconductor wafer need to be arranged. To enable such transfer, a system for transporting an electronic component is used. Such system may also be referred to as pick-and-place apparatus or die placement apparatus, such as a die bonder or die sorter.

The abovementioned systems rely on relatively heavy and expensive mechanical and mechatronic modules to assemble small (< 1mm) components. In relation to the assembled components, the assembly equipment weighs at least seven orders of magnitude more, resulting in complex, expensive equipment. Furthermore, this approach poses limits to assembly speeds.

Levitation in acoustic or magnetic fields has been studied extensively for various assembly applications and are promising technologies to address the abovementioned problem. If the force field can be controlled accurately and fast, the machine complexity can be greatly simplified. Furthermore, no mechanical contact between the component and a pickup tool is required, lowering the risk of damage. In addition, without any mechanical components blocking the view, smart vision can be integrated to track the position of the small objects in the force field and to support alignment and inspection tasks.

For application in semiconductor assembly, several issues associated with levitation in acoustic or magnetic fields still need to be overcome. For example, the achievable positional accuracy of the levitating component should be acceptable given a particular application. In prior art approaches, the position of the levitating component suffers from oscillation thereby causing a positional inaccuracy when arranging the component onto a carrier. The Applicant has found that this positional inaccuracy has prevented successful application of the levitation concept in the abovementioned transporting systems.

### SUMMARY

Aspects of the present disclosure relate to a system for transporting an electronic component that addresses the abovementioned problem of positional inaccuracy. To this end, according to a first aspect of the present disclosure, a system is provided that comprises a carrier for carrying the electronic component, and a transducer system comprising a plurality of transducers, wherein the transducer system is configured for generating a levitation field in which the carrier levitates. The system further comprises an input unit for arranging the electronic component onto the carrier, and an output unit for receiving the electronic component from the carrier. The system also comprises a controller for controlling the transducer system to change the levitation field for the purpose of moving the carrier from the input unit to the output unit.

Compared to prior art approaches, the system according to the present disclosure uses a carrier for carrying the electronic component to be transferred. Properties of this carrier, such as its shape, weight, density, or the like, can be tailored to the specific levitation field that is used. For example, when using diamagnetic levitation, the carrier can be made of suitable magnetic material. Furthermore, by using a different shape, weight, and/or density than the electronic component to be transferred a more stable positioning can be obtained. Compared to the electronic component to be transferred, the carrier can be made relatively large and flat. This ensures less positional oscillations in the levitation field when compared to the situation in which the electronic component to be transferred was levitating in the levitation field by itself.

The input unit may further comprise a first dispensing unit for dispensing a first attaching agent onto the carrier. This first attaching agent is configured to attach the electronic component to the carrier when receiving the electronic component. The first attaching agent may be a liquid, such as water. In this case, the electronic component may be held to the carrier by means of fluidic adhesion. In other embodiments, other liquids may be used, such as liquids having adhesive properties. The liquid is generally applied by allowing a suitable quantity of liquid to be dropped onto the carrier. To prevent the dispensing of the liquid from disturbing the levitation field, the dispensing unit is typically arranged at some distance from the carrier. Furthermore, the carrier may comprise a recess or other structure that aligns the droplet of the liquid and/or that forces the droplet to assume a pre-defined position and/or shape on the carrier. Furthermore, such recess or other structure may have an elongated shape that would cause the electronic component to assume a predefined position relative to the carrier when it is received from the input unit. Such alignment may be preferred when the electronic component is also elongated itself and needs to be arranged on a substrate or the like with a particular orientation.

The output unit may comprise a detaching unit for breaking the attachment of the electronic component to the carrier by the first attaching agent. Typically, the detaching unit breaks the attachment remotely, i.e. without mechanical interaction. This may be achieved by imparting some suitable form of energy onto the first attaching agent to cause the attachment to be broken. The attachment may be broken because the first attaching agent loses its adhesive properties and/or because the first attaching agent is at least partially removed. For example, the first attaching agent may comprise a photo-absorbing material, and the detaching unit may comprise a light source configured for illuminating the first attaching agent for the purpose of breaking the attachment by the first attaching agent. The light source may for example comprise a laser source. The first attaching agent may be configured to at least partially evaporate because of illuminating the first attaching agent. In this case, the received optical energy is converted into thermal energy that heats the first attaching agent to the point that it evaporates. Additionally, or alternatively, the absorption of heat may also cause the first attaching agent to exert a propulsion force onto the electronic component, thereby pushing the electronic component away from the carrier.

The output unit may comprise a holding unit, such as a chuck, for holding a substrate on which the electronic component is to be arranged. Typically, the substrate is plate-shaped and may comprise a printed circuit board. The output unit may also comprise a second dispensing unit for dispensing a second attaching agent onto the substrate for the purpose of attaching the electronic component received from the carrier on the substrate. Contrary to the first attaching agent, the second attaching agent should generally ensure a permanent fixation of the electronic component on the substrate. The second attaching agent may comprise an adhesive glue, solder, or the like.

The electronic component may be a semiconductor die. Furthermore, the input unit may be configured for holding a wafer comprising a plurality of physically separated semiconductor dies. Such a wafer may be a structured wafer in which dies are arranged in a different order than the order they were in during manufacturing and/or in which dies are arranged that originate from different wafers. Alternatively, such a wafer may also include a wafer that is obtained after dicing the wafer to physically separate the individual dies.

The input unit may further comprise a releasing unit for releasing a semiconductor die from the wafer causing and/or allowing the released semiconductor die to be arranged on the carrier. The releasing unit is generally configured for releasing one semiconductor die at a time. The physically separated semiconductor dies may be attached to a tape, foil, or film using a third attaching agent.

The releasing unit may comprise a needle and an actuator for bringing the needle into and out of engagement with a die among the plurality of physically separated dies on the wafer by pushing on a backside of the tape, foil, or film. As a result of this engagement, the tape, foil, or film may bulge outwardly, and the corresponding semiconductor detaches from the tape, foil, or film. Alternatively, the releasing unit may comprise a light source for illuminating the third attaching agent for the purpose of breaking the attachment of a semiconductor die among the physically separated semiconductor dies to the tape, foil, or tape, by the third attaching agent. In this case, the third attaching agent is as a photo-absorbing adhesive. Upon absorbing the optical energy, the third attaching agent may undergo a chemical transition thereby losing its adhesive properties. Alternatively, the third attaching agent may at least partially evaporate and/or ablate, thereby releasing the semiconductor die.

Relative to the Earth's gravitational field, the input unit can be arranged above the carrier at a time of arranging the electronic component on the carrier. In this case, the input unit can be configured to cause the electronic component to fall onto the carrier. Additionally, or alternatively, relative to the Earth's gravitational field, the output unit can be arranged below the carrier at a time of receiving the electronic component from the carrier. In this case, the output unit can be configured to cause the electronic component to fall from the carrier. Alternatively, aspects of the present disclosure relate to embodiments in which the carrier is moved against the wafer, i.e. making physical contact, when receiving the semiconductor die, and/or in which the carrier is moved against the substrate when arranging the semiconductor die onto the substrate. This equally applies to embodiments in which other electronic components are transferred.

The plurality of transducers may comprise a plurality of acoustic transducers configured for generating soundwaves. In this case, the levitation field is an acoustic levitation field. The soundwaves generated by the plurality of acoustic transducers may have a frequency in a range between 20 Hz and 200 kHz. The transducers can be configured to generate an acoustic potential well in which the carrier and the component carried by the carrier can be trapped. The controller can be configured for controlling the transducer system to change a position and/or orientation of the acoustic potential well for the purpose of moving the carrier.

The carrier may have a first surface configured to support the electronic component, wherein a maximum thickness of the carrier in a direction perpendicular to the first surface is less than 1/3 times a wavelength of the soundwaves generated by the acoustic transducers. Generally, the combination of carrier and electronic component should be contained in the acoustic potential well to allow proper control of position and orientation in the levitation field. A surface area of the first surface can be at least 3 times greater than a maximum cross-sectional area of the electronic component, more preferably 10 times greater. Typically, the acoustic potential well is larger in a direction perpendicular to a propagation direction of the soundwaves than in a direction parallel to the propagation direction. For example, when the transducers are arranged to emit soundwaves in a vertical direction, the acoustic potential well is much wider than it is high. Furthermore, the acoustic potential well and/or the carrier can be elongated. This allows for self-alignment of the carrier in the acoustic potential well allowing a predictable orientation of the electronic component when it is released from the carrier in the output unit.

The first surface can be a rectangular or oval. Moreover, the carrier can be made from one or more of the materials out of the group consisting of polymers and/or low-density materials such as low-density metals e.g. magnesium or beryllium, low-density composite materials e.g. carbon-based, or low-density ceramics, wherein the low-density material preferably has a density less than 2000 kg/m³.

The transducer system may comprise one or more reflectors for reflecting the soundwaves emitted by the transducers for the purpose of creating standing waves. Generally, the acoustic levitation field comprises a pattern of standing waves. These standing waves may be generated by letting two or more oppositely directed soundwaves interfere. When using one or more reflectors, the generated soundwaves interfere with their reflections for the purpose of generating the standing wave pattern.

The system may comprise a housing in which the acoustic field is generated, wherein the one or more reflectors are at least partially formed by an inner wall of the housing. When a wafer is used holding the electronic component to be transferred, this wafer may partially form one or more reflectors. For example, the wafer may be arranged in an upside-down manner relative to the Earth's gravitational field with the transducers being arranged below the wafer and the carrier in between the transducers and the wafer. In such case, the standing wave pattern is generated using the soundwaves emitted by the transducers and the soundwaves that are reflected off the wafer.

Similarly, at the output unit, the substrate may partially form one or more reflectors. For example, the substrate may be arranged upwardly oriented relative to the Earth's gravitational field with the transducers being arranged above the substrate and the carrier in between the transducers and the substrate. In such case, the standing wave pattern is generated using the soundwaves emitted by the transducers and the soundwaves that are reflected off the substrate.

The system may generally be divided into a number of parts or segments. For example, the system may comprise an input part in which the input unit is arranged in combination with some of the plurality of transducers. The system may further comprise an output part in which the output unit is arranged in combination with some of the plurality of transducers, and a transfer part arranged in between the input part and the output part in which some transducers of the plurality of transducers are arranged.

Some of the plurality of transducers arranged in the transfer part can be configured for rotating and/or flipping the carrier while supporting the electronic component arranged thereon to cause the electronic component to face the output unit at a time when the output unit receives the electronic component from the carrier. For example, in the embodiments discussed above, the input unit was arranged above the carrier and the output unit below the carrier at a time of arranging the electronic component onto the carrier or receiving the electronic component from the carrier, respectively. To allow this positioning of the input unit and the output unit, the carrier with the electronic component needs to be rotated and/or flipped. Generally, the rotation and/or flipping is performed about a rotational axis that is perpendicular to the direction in which the transducers and input unit are separated. For example, when arranging the input unit vertically separated from the transducers, the rotational axis may be horizontal.

The system may further comprise a localization system for determining a position and/or orientation of the carrier and/or the electronic component carried by the carrier. In this case, the controller is configured to control the transducer system in dependence of the determined position and/or orientation. The localization system may be configured to determine the position and/or orientation of the electronic component by itself. Alternatively, the localization system may be configured to determine the position and/or orientation of the carrier, with the electronic component having a pre-defined position and/or orientation relative to the carrier.

The localization system may comprise a vision system. This 3D vision system determines the position and/or orientation inside the housing in which the acoustic field is generated. This system may comprise a stereo camera setup and/or structured lighting for triangulation-based measurements. Alternative imaging techniques are based on computational imaging and digital holography. The minimal measurement frequency can be around 1kHZ. Additionally, this vision system may be configured to align the carrier with the electronic component on the input unit for correcting positioning of the semiconductor component on the carrier. The vision system can also be used to align the semiconductor component on the carrier with the substrate for correct positioning of the electronic component on the substrate. Additionally, or alternatively, the localization system can be configured to determine the position and/or orientation of the carrier and/or the position and/or orientation of the electronic component carried by the carrier using echo-localization. When using an acoustic levitation field, the plurality of transducers can be further configured for generating soundwaves used for performing this echo-localization. These soundwaves may have a different frequency when compared to the soundwaves for creating the levitation field to avoid disturbing the levitation field.

The system can be configured to transport a plurality of electronic components simultaneously. For example, when using acoustic levitation, a plurality of acoustic cavities are generated. In this case, the transducer system can be configured to trap each of the plurality of electronic components that is to be transported simultaneously in a respective acoustic potential well.

Furthermore, the controller can be configured for returning the carrier from the output unit to the input unit after having transported the electronic component for the purpose of transporting of an other electronic component. In particular when using a first attaching agent such as water, the carrier can be re-used multiple times as the contamination of the carrier caused by the first attaching agent is limited or non-existent.

According to a second aspect of the present disclosure a method for transporting an electronic component is provided that comprises generating a levitation field in which a carrier is levitating, arranging the electronic component onto the carrier while the carrier is levitating, changing the levitation field for moving the carrier with the electronic component carried by the carrier, and removing the electronic component from the carrier.

Preferably, the levitation field is an acoustic levitation field, although the present disclosure equally relates to other types of levitation fields, such as a magnetic levitation field. In case the levitation field is an acoustic levitation field, the carrier and the electronic component carried by the carrier are trapped in an acoustic potential well. Moving the carrier with the electronic component carried by the carrier may then comprise changing a position and/or orientation of the acoustic potential well.

The electronic component can be a semiconductor die among a plurality of physically separated semiconductor dies comprised by a wafer. Arranging the electronic component onto the carrier may comprise releasing a semiconductor die from the wafer causing and/or allowing the released semiconductor die to be arranged on the carrier. The physically separated semiconductor dies may be attached to a tape, foil, or film using a third attaching agent, such as an adhesive. In this case, releasing a semiconductor die may comprise illuminating the third attaching agent for the purpose of breaking the attachment of a semiconductor die among the physically separated semiconductor dies by the third attaching agent.

Generating a levitation field may comprise using a plurality of transducers for generating soundwaves and allowing the soundwaves to be reflected by one or more reflectors for the purpose of creating standing waves, wherein the one or more reflectors are at least partially formed by the wafer.

The method may further comprise dispensing a first attaching agent on the carrier prior to arranging the electronic component on the carrier, wherein the first attaching agent attaches the electronic component to the carrier. In this case, removing the electronic component may comprise breaking the attachment of the electronic component to the carrier by the first attaching agent. The first attaching agent may comprise a photo-absorbing material and said breaking the attachment may comprise illuminating the first attaching agent using a light source.

The method may comprise allowing a plurality of carriers and a corresponding plurality of electronic components carried by the carriers to simultaneously levitate in the levitating field. In this case, the carriers and corresponding electronic components may be trapped in respective acoustic cavities. The method may comprise simultaneously moving the carriers with the electronic components carried by the carriers by changing a position and/or orientation of the acoustic cavities.

According to a third aspect of the present disclosure, a system for transporting an electronic component is provided that comprises a carrier having a first side, and a droplet dispensing unit for dispensing a droplet of liquid on the first side of the carrier. The system further comprises a separating unit for releasing an electronic component from a donor substrate and for allowing the released electronic component to be held by the droplet on the first side of the carrier. The system additionally comprises an optical source for emitting a pulse of light through the carrier towards an interface between the droplet and the carrier to locally vaporize the droplet thereby causing a jet to be formed from the droplet that on one end holds the electronic component and that subsequently breaks to thereby release the electronic component onto a target substrate.

The system according to the third aspect may be part of a specific implementation or embodiment of the system according to the first aspect. For example, the droplet dispensing unit is a particular embodiment of the first dispensing unit, the droplet itself a particular embodiment of the first attaching agent, and the optical source a particular embodiment of the detaching unit.

The system according to the third aspect focuses on the use of light for releasing electronic components from the carrier. More in particular, the Applicant has found that by vaporizing the droplet only locally, i.e., instead of fully, a gas expansion will occur inside the droplet that will change the shape of the droplet. More specifically, the gas expansion will change the droplet into a jet that on one end holds the electronic component. This jet will break thereby releasing the electronic component from the donor substrate allowing it to be arranged onto a target substrate.

Similar to the system according to the first aspect, the electronic component can be a semiconductor die, a packaged semiconductor die, a light-emitting diode or other electronic component that is relatively small so that it can be transported using levitation although other means of transporting the electronic component are not excluded. The donor substrate can be in the form of a carrier that supports a plurality of electronic components. A particular example of a donor substrate is a diced or structured semiconductor wafer.

The acceptor substrate can be a substrate or carrier on which a plurality of the electronic components needs to be arranged.

The optical source can be configured to emit the pulse of light such that the energy provided by the pulse of light for heating the droplet is less than the energy that is required to fully vaporize the droplet, preferably at least 10 times less, more preferably at least 50 times less. The pulse of light will at least partially be absorbed by the carrier and/or the droplet, which will convert the energy at least partially into heat. The heat delivered to the droplet is less than what is required for fully vaporizing the droplet.

Generally, heat is not uniformly provided to the droplet. For example, when the heat comes from the first side of the carrier, the part of the droplet closest to the interface between the droplet and the interface will heat up more quickly than the parts of the droplet that are more remote from the interface. Through thermal conduction, heat will spread through the droplet.

According to the third aspect of the present disclosure, energy is provided in such an intense burst that sufficient energy is supplied to the droplet locally, i.e. at or near the interface with the carrier, to cause the droplet to locally vaporize before at least a large part of the heat has spread throughout the droplet by means of conduction. This local vaporization will result in gas expansion inside the droplet that will in turn deform the droplet. More specifically, a jet will be formed that on one end is connected to the first side of the carrier and that on the other end is connected to the electronic component. However, the droplet is not able to maintain this shape. Due to the gas expansion, the jet will finally break thereby releasing the electronic component from the carrier. At this stage, part of the liquid will remain attached to the carrier and some of the liquid will remain attached to the electronic component.

The liquid to be used for holding the electronic component can be water or water-glycerol solution.

The jet is formed in such a manner that its longitudinal axis extends from a first plane in a direction perpendicular to that plane. Typically, the carrier has a substantially flat shape, such as a disc or plate shape. The first plane is parallel to and/or is defined by the first side of the carrier. To improve energy efficiency, a spot of the emitted pulse at or near the interface between the droplet and the carrier is equal to or smaller than a contact area along the first plane across which the droplet contacts the carrier.

The optical source can be configured to emit a pulse that carries an energy that is higher than 0.03mJ per cm^2 of irradiated surface, more preferably higher than 4mJ per cm^2 of irradiated surface, wherein a pulse width of the emitted pulse is less than 200ns, more preferably less than 50ns, wherein the optical source preferably comprises a laser.

The carrier may comprise a carrier body and a coating arranged on the carrier body, wherein the coating at least partially forms the first side of the carrier, wherein the carrier is at least partially but preferably entirely transparent for the emitted pulse, and wherein the coating is at least partially but preferably entirely opaque for the emitted pulse. Because the coating can be relatively thin relative to the substrate, the use of an opaque coating and transparent carrier allows the optical energy to be absorbed in a relatively small volume close to the droplet of liquid.

The carrier can be made of a material chosen from the group consisting of glass, quartz, and polymethyl methacrylate, whereas the coating can be made of a material chosen from the group consisting of gold, silver, and titanium. The carrier can be configured like the carrier according to the first aspect of the present disclosure.

The coating can be patterned, for example using lithography techniques. For example, the coating can be patterned such that the coating is only present at the position where it is to contact the droplet. In some embodiments, the coating can be in the form of a pad that can be used as an alignment mark when dispensing the droplet of liquid. The part of the coating that is in direct contact with the droplet need not be a continuous layer. For example, spaces may exist between segments of the coating. Such pattern will influence the process of local vaporization and the subsequent gas expansion.

The coating is preferably designed so that it does not substantially ablate, wear, or deteriorate at least for a significant number of times it is used for transferring an electronic component.

The carrier may comprise a focusing structure for focusing the emitted pulse towards the interface between the carrier and the droplet. An example of such focusing structure is a micro-lens provided on or formed in the carrier or carrier body. In some embodiments, the micro-lens is of the same material as the carrier or carrier body and can be formed using known techniques such as patterning and etching. In other embodiments, the micro-lens is formed separately from the carrier or carrier body and is afterwards attached to the carrier or carrier body. By focusing the light, a spot size at the interface between the droplet and the carrier can be reduced relative to the width of the pulse when it first impinges on the carrier.

The carrier may comprise a recess or protrusion formed in the carrier or carrier body at the first side of the carrier. This recess or protrusion is configured to support the droplet. The aforementioned coating may only be arranged at a position of this recess or protrusion.

The droplet dispensing unit may be configured for arranging multiple droplets on the carrier. These droplets may each support a same electronic component or they may support multiple electronic components. The apparatus may further comprise an optical splitter that receives the emitted pulse from the optical source and that generates a plurality of sub-pulses that are each emitted towards a different droplet among the plurality of droplets. The aforementioned features regarding a coating, recess, or protrusion may also apply to at least some but preferably all of the droplets.

The system may further comprise a levitation system for levitating the carrier, wherein the levitation system preferably comprises a transducer system comprising a plurality of transducers, the transducer system being configured for generating a levitation field in which the carrier levitates. The system may further comprise an input unit for arranging the electronic component onto the carrier, wherein the input unit comprises the separating unit, and the system may comprise an output unit for receiving the electronic component from the carrier, wherein the output unit comprises the optical source. The system may additionally comprise a controller for controlling the transducer system to change the levitation field for the purpose of moving the carrier from the input unit to the output unit. This same controller can be used for controlling the optical source and/or separating unit.

It should be apparent to the skilled person that the system according to the third aspect of the present disclosure can be fully implemented in the system according to the first aspect of the present disclosure. Accordingly, the present disclosure should not be construed as excluding the application of features of the system according to the first aspect that have not been explicitly described in combination with the system according to the third aspect.

According to a fourth aspect, the present disclosure provides a method for transferring an electronic component that comprises the steps of dispensing a droplet of liquid on a first side of a carrier, releasing an electronic component from a donor substrate and allowing the released electronic component to be held by the droplet, emitting a pulse of light through the carrier towards an interface between the droplet and the carrier to locally vaporize the droplet thereby causing a jet to be formed from the droplet that on one end holds the electronic component and that subsequently breaks to thereby release the electronic component onto a target substrate.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 schematically illustrates the components of an embodiment of a system for transporting an electronic component in accordance with an aspect of the present disclosure;
Figure 2 illustrates a first embodiment of a system for transporting an electronic component in accordance with an aspect of the present disclosure;
Figure 3 illustrates a second embodiment of a system for transporting an electronic component in accordance with an aspect of the present disclosure;
Figure 4 illustrates a process of releasing a semiconductor die from a carrier in accordance with an aspect of the present disclosure; and
Figure 5 illustrates different embodiments for holding one or more semiconductor dies using one or more droplets in accordance with the present disclosure.

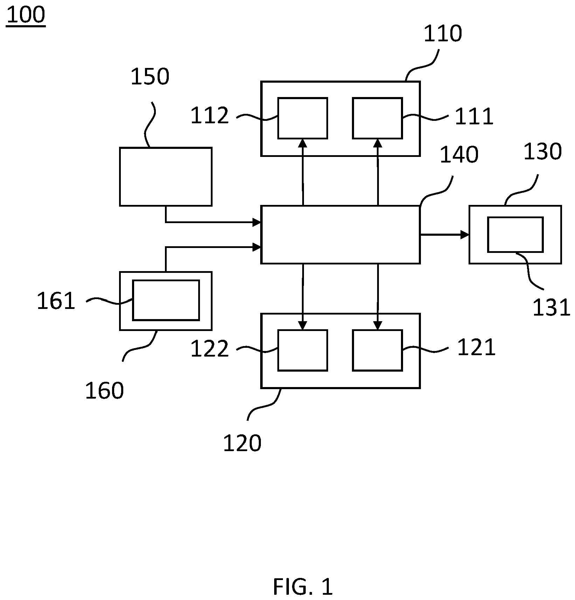

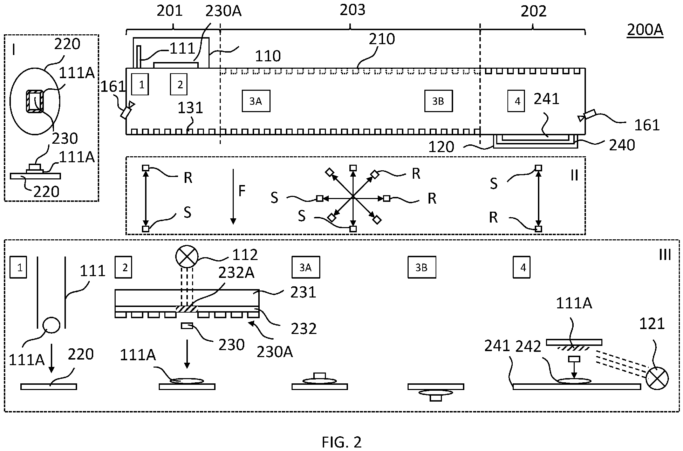

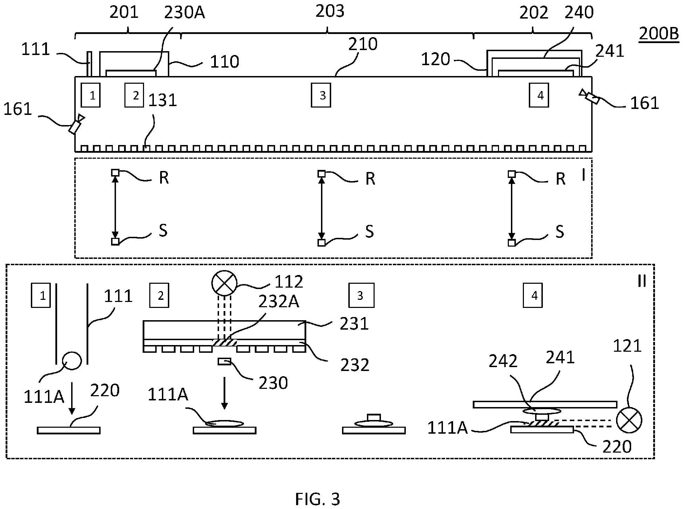

Figure 1 schematically illustrates the components of an embodiment of a system 100 for transporting an electronic component in accordance with an aspect of the present disclosure. The components shown in figure 1 are also illustrated in figures 2 and 3. In figures 1-3, the electronic component to be transferred is a semiconductor die. This semiconductor die is provided in the form of a diced semiconductor wafer that comprises a plurality of physically separated semiconductor dies. The physically separated semiconductor dies are attached to a tape, foil, or film using a photo-absorbing adhesive.

System 100 comprises an input unit 110 for arranging the electronic component to be transferred onto a carrier. Input unit 110 comprises a first dispensing unit 111 for dispensing a first attaching agent onto the carrier, and a releasing unit 112 for releasing a semiconductor die from the wafer causing and/or allowing the released semiconductor die to be arranged on the carrier.

System 100 further comprises an output unit 120 for receiving the electronic component from the carrier onto a substrate in the form of a printed circuit board. Output unit 120 comprises a detaching unit 121 for breaking the attachment of the electronic component to the carrier by the first attaching agent. Output unit 120 optionally further comprises a second dispensing unit 122 for dispensing a second attaching agent onto the substrate for the purpose of attaching the electronic component received from the carrier on the substrate.

System 100 comprises a transducer system 130 comprising a plurality of transducers 131 that each emit a soundwave having a frequency in the range between 20kHz and 200kHz. The transducer system is configured for generating a levitation field in which the carrier levitates. System 100 also comprises a controller 140 for controlling transducer system 130 to change the levitation field for the purpose of moving the carrier from input unit 110 to output unit 120. Controller 140 further controls first dispensing unit 111, releasing unit 112, detaching unit 121, and optionally second dispensing unit 122.

System 100 comprises a localization system 150 for determining a position and/or orientation of the carrier and/or the electronic component carried by the carrier. Controller 140 is configured to control transducer system 130 in dependence of the determined position and/or orientation. Optionally, system 100 may comprise an inspection system 160 for inspecting the electronic component and/or carrier during various stages of transporting the electronic component. Controller 140 can be configured to control transducer system 130 in dependence of an output of inspection system 160. Inspection system 160 may comprise one or more optical cameras 161.

Next, two embodiments of a system for transporting an electronic component in accordance with an aspect of the present disclosure will be described in more detail referring to figures 2 and 3. Components in these embodiments that are identical or similar to the components illustrated in figure 1 will be referred to using the same reference signs.

Figure 2 illustrates a system 200A that comprises an input part 201 in which input unit 110 is arranged in combination with some of the plurality of transducers 131. System 200A further comprises an output part 202 in which output unit 120 is arranged in combination with some of the plurality of transducers 131. In addition, system 200A comprises a transfer part 203 arranged in between input part 201 and output part 202.

System 200A comprises a housing 210 in which transducers 131 are arranged. Housing 210 is made from acoustically reflective material. The soundwaves emitted by transducers 131 reflect off housing 210 causing a standing wave pattern to be generated inside housing 210. The standing wave pattern comprises a plurality of acoustic cavities.

As shown, input unit 110 comprises a dispensing unit 111 that arranges a droplet 111A of liquid, such as water, on carrier 220. This is shown in insert III of figure 2. Input unit 110 also comprises a releasing unit in the form of a laser source 112. Controlled by controller 140, laser source 120 can be activated for illuminating that part 232A of photo-absorbing adhesive 232 by which semiconductor die 230 to be transferred is attached to a wafer tape 231. After illuminating, photo-absorbing adhesive 232A will lose its attachment with semiconductor die 230 causing the latter to fall down towards carrier 220, where it is attached to carrier 220 using liquid 111A.

As shown in insert I of figure 2, showing a top view and side view of semiconductor die 230 attached to carrier 220 using a droplet of liquid 111A, carrier 220 has an oval flat shape. This shape may correspond to a shape of the acoustic cavities that are generated in housing 210. For example, by using elongated shapes, carrier 220 will align itself in the elongated acoustic potential well.

Inside input part 201, transducers 131 are arranged at one side of housing 210, whereas at an opposing side of housing 210 a wafer 230A is arranged that holds a plurality of semiconductor dies 230. As shown in insert II of figure 2, transducers 131 act as a source S of soundwaves and wafer 230A acts as a reflector R. Here, it is noted that insert II illustrates the configuration of transducers 131 at various positions in system 200A. Insert II corresponds to a cross-sectional view taken perpendicular to the horizontal direction from input part 201 to output part 202.

The soundwaves generated by transducers 131 and the soundwaves reflected off wafer 230A and housing 210 jointly create a standing wave pattern. Insert II also illustrates the Earth's gravitational force F demonstrating that if a semiconductor die 230 is released from wafer 230A it will fall towards carrier 220.

Inside second part 203, transducers 131 are arranged along an inner wall of housing 210 at various vertical positions. Moreover, the upper part of housing 210 acts as reflectors R and transducers 131 arranged in the lower part of housing 210 act as sources S. In other embodiments, transducers 131 are arranged both in the upper and lower parts of housing 210. The configuration of transducers 131 allows the acoustic cavities to be rotated and/or flipped along a rotational axis that is parallel to the horizontal direction from input part 201 to output part 202 or along a horizontal axis that is perpendicular to the horizontal direction from input part 201 to output part 202.

Output unit 120, which is arranged inside output part 202, comprises a holding unit 240 for holding a substrate 241 on which semiconductor die 230 needs to be arranged. Output unit 120 further comprises a detaching unit in the form of a laser source 121. Substrate 241, which can be in the form of a printed circuit board, is provided with an attaching agent 242. When laser source 121 illuminates the droplet of liquid 111A by which semiconductor die 230 is attached to carrier 220, the attachment between semiconductor die 230 and carrier 220 is broken and semiconductor die 230 falls on attaching agent 242 for allowing semiconductor die 230 to become fixated relative to substrate 241. It should be noted that attaching agent 242 may comprise adhesive glue, solder, or the like, which may require an additional step, such as curing and/or heating, to be performed to achieve the fixation.

As shown in insert II, the configuration of transducers 131 in output part 202 is flipped when compared to input part 201. Consequently, carrier 220 and semiconductor die 230 carried by carrier 220 need be rotated or flipped between input part 201 and output part 202. As explained before, this is performed inside transfer part 203.

Localization for determining a position and/or orientation of carrier 220 and/or semiconductor die 230 can obtained by using echo-localization. The soundwaves required for performing echo-localization can be emitted using transducers 131 albeit at a different frequency. Controller 140 is configured for controlling transducers 131 in dependence of a determined position of carrier 220 and/or semiconductor die 230. More in particular, the position and/or orientation of the acoustic potential well in which carrier 220 and semiconductor die 230 are trapped is changed. Such change can be effectuated by changing an amplitude and/or phase of the soundwaves that are generated by transducers 131.

Insert III illustrates the position of carrier 220 and semiconductor die 230 at various stages during transport from input unit 110 to output unit 120. As shown, using numerals 3A and 3B, carrier 220 is flipped when inside transfer part 203.

System 200A also comprises optical cameras 161 to monitor the transfer process and/or for performing various quality checks of carrier 220 and/or semiconductor die 230. Based on the output of cameras 161 or the output of an image processing unit that processes the images of optical cameras 161, controller 140 may control transducers 131 for performing corrective measures. For example, if a damaged and/or incorrectly placed semiconductor die 230 is detected by an optical camera 161, controller 140 may control transducers 131 to move carrier 220 to a separate location, optionally also provided with a detaching unit, for discarding semiconductor die 230 and/or carrier 220.

After semiconductor die 230 has been arranged on substrate 241, carrier 220 may return to input part 201 where it will receive a next droplet of liquid 111A for transporting a next semiconductor die 230 on wafer 230A.

Although figure 2 illustrates the process of transporting a single semiconductor die 230, the concept can equally be used for transporting a plurality of semiconductor dies 230 at a time. This is made possible because the standing wave pattern comprises a plurality of acoustic cavities. Optionally, releasing unit 112 may be configured to substantially simultaneously release a plurality of semiconductor dies 230 to fall on a corresponding plurality of carriers 220. The same holds for dispensing unit 111 and detaching unit 121.

Figure 3 illustrates a system 200B that differs from system 200A in that carrier 220 with semiconductor die 230 arranged thereon is brought into contact with attaching agent 242 for the purpose of arranging semiconductor die 230 on substrate 241. Put differently, in this case, semiconductor die 230 will not fall under the influence of the Earth's gravitational field towards substrate 242. Rather, semiconductor die 230 is pushed into and/or against attaching agent 242. The adhesive power of attaching agent 242 may be superior to that of liquid 111A in which case detaching unit 111 may be omitted.

An advantage of the figure 3 embodiment is that no rotation or flipping of carrier 220 is required inside transfer part 203. Consequently, the arrangement of transducers 231 inside transfer part 203 can be different, but need not be, relative to transfer part 203 of system 200A.

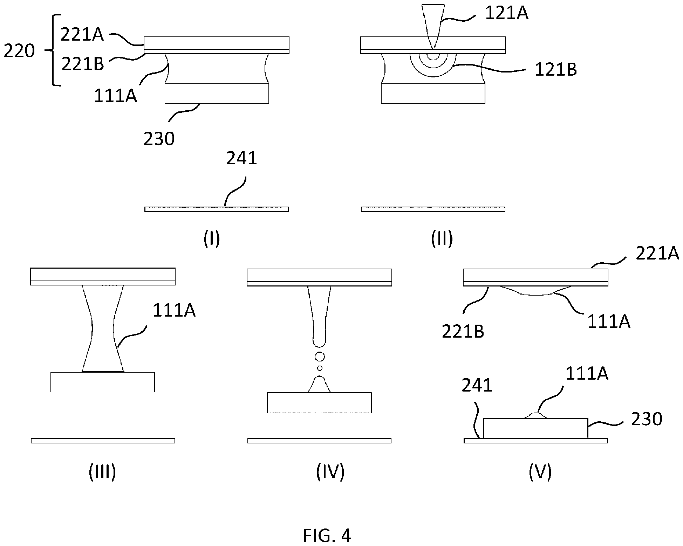

Figure 4 illustrates a process of releasing a semiconductor die from a carrier in accordance with an aspect of the present disclosure. More specifically, figure 4 illustrates five different steps (I)-(V) in which an electronic component 230 is released from a carrier 220.

In figure 4, carrier 220 comprises a transparent carrier body 221A made of glass which is covered by a coating made of gold. More in particular, carrier body 221A is disc shaped having a thickness of 1mm and a surface area of 3.14mm^2, whereas coating 211B has a thickness of 60 nm. Generally, carrier body 221A has a circular or oval top and bottom surface, of which the surface area lies in a range between 1 and 5mm^2, and wherein a thickness of carrier body 221A lies within a range between 0.5 and 2mm. In some embodiments, coating 221B may be absent. In such embodiments, the abovementioned ranges for carrier body 221A apply to carrier 220.

A droplet 111A of water is attached to coating 221B. In turn, a semiconductor die 230 is connected to droplet 111A. An example of dispensing the droplet is shown in figure 2, insert III, numeral 1, whereas numeral 2 illustrates the release of semiconductor die 230 from a wafer 230A using a light source 112.

Figure 4 further illustrates a substrate or carrier 241 on which semiconductor die 230 is to be released. Figure 4, step (I) illustrates the position of carrier 241 prior to releasing semiconductor die 230. This position corresponds to the position indicated using numeral 4 in insert III of figure 2.

Figure 4, step (II) illustrates how a light source, such as light source 121 in figure 2, emits a pulse 121A of light towards the interface between carrier 220 and droplet 111A, more in particular between coating 221B and droplet 111A. Pulse 121A has a spectrum that lies in between 425 and 475 nm for which carrier body 221A is transparent but for which coating 221B is opaque.

Pulse 121A is absorbed by coating 221B, which releases the absorbed energy as heat to droplet 111A. The amount of heat released to droplet 111A is such that the liquid of droplet 111A nearest to the interface between droplet 111A and coating 221B vaporizes before a remainder of droplet 111A has gained a considerable increase in temperature. This local vaporization of the liquid of droplet 111 causes a gas expansion 121B inside droplet 111A. As a result of gas expansion 121B, a shape of droplet 111A will change. More specifically, the shape of droplet 111A will transform into a jet. One end of this jet is connected to coating 221B, whereas the other end is connected to semiconductor die 230. At a given moment in time, the jet thus formed breaks and semiconductor die 230 is released and is propelled and/or falls towards substrate 241. These steps are shown as steps (III)-(IV) in figure 4.

As a final step, shown as step (V) in figure 4, semiconductor die 230 is arranged on substrate 241. Here, an adhesive layer (not shown), such as solder, can be arranged in between substrate 241 and semiconductor die 230. This adhesive layer corresponds to the second attaching agent used in the system according to the first aspect of the present disclosure. Furthermore, as shown in step (V), part of droplet 111A remains attached to carrier 220, whereas an other part is connected to semiconductor die 230. In some applications, substrate 241 is subjected to a thermal treatment for heating the adhesive layer thereby making the attachment between semiconductor die 230 and substrate 241 permanent. During such treatment, the remaining part of droplet 111A that is still present on semiconductor die 230 will vaporize. The part of droplet 111A that is still present on carrier 220 can either be re-used or be removed, for example by means of vaporization.

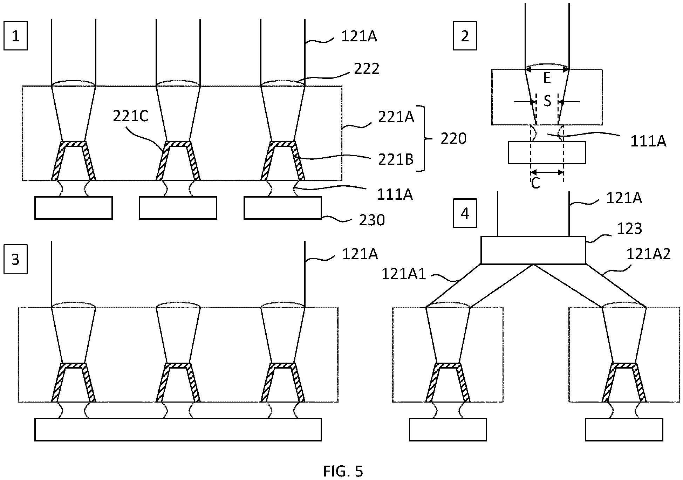

Figure 5 illustrates different embodiments for holding one or more semiconductor dies using one or more droplets in accordance with the present disclosure. Shown as embodiment 1, carrier 220 comprises a transparent body 221A that includes a plurality of recesses 221C. Coating 221B is applied inside recesses 221C only. Furthermore, a plurality of droplets 111A is arranged on carrier 220. Each droplet 111A extends partially inside and partially outside a given recess 221C. In this embodiment, a plurality of semiconductor dies 230 is supported by droplets 111A and each droplet 111A is heated using a separate pulse 121A. Furthermore, each pulse 121A is focused onto a respective recess 221C using a micro-lens 222.

Embodiment 4 in figure 5 shows how separate pulses can be generated. In this embodiment, a single incoming pulse 121A is split, by an optical splitter 123, into a plurality of sub-pulses 121A1, 121A2, each directed to a separate droplet. However, the present disclosure is not limited thereto. For example, embodiment 3 in figure 5 illustrates how a wide pulse 121A can be used to simultaneously irradiate a plurality of droplets.

Embodiment 2 of figure 5 illustrates that in some embodiments, coating 221B can be omitted. In this case, carrier 220, which can have the same material composition as aforementioned carrier body 221A, can be transparent allowing pulse 121A to heat up droplet 111A directly. Although possibly less energy efficient than the other embodiments, this embodiment can still be employed for the formation of jets using high-energy light pulses.

In the figure corresponding to embodiment 2 in figure 5, a spot size S is shown, in cross section, of pulse 121A. Spot size S is smaller than an area C along which droplet 111A contacts carrier 220. Having a smaller spot size than the contact area allows the generation of heat only at the position of the droplet(s). Moreover, the smaller spot size reduces the chance of the droplet 111A being released from carrier 220 before a jet has been fully formed.

Embodiment 2 in figure 5 also indicates, in cross section, an irradiated surface E. An energy contained in the pulse of light is higher than 0.03mJ per cm^2 of irradiated surface (E), more preferably higher than 4mJ per cm^2. In addition, a pulse width of the emitted pulse is less than 200ns, more preferably less than 50ns. To this end, optical source 121 may comprise a laser. It is further noted that the present disclosure particularly relates to embodiments in which each electronic component is released using a single pulse.

Referring back to embodiment 4 in figure 5, it is possible that a single pulse 121A is used for simultaneously transmitting pulses to a plurality of semiconductors held by a plurality of carriers. Splitter 123 may for example comprise a plurality of movable mirrors, such as micro-electromechanical systems, MEMS, mirrors, of which the orientation and/or position can be individually controlled.

In the above, the present invention has been described using detailed embodiments thereof. However, the present invention is not limited to these embodiments. Instead, various modifications are possible without departing from the scope of the present invention which is defined by the appended claims and their equivalents.

For example, the system is generally adapted for transporting an electronic component through air or another gaseous medium in case acoustic levitation is employed. However, the present disclosure does not exclude other media in which an electronic component can be transported such as a liquid. In case a liquid is used instead of air, the frequency of the generated soundwaves is generally different. For example, the frequency can be in the range between 100kHz and 1MHz.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalization thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

The term "comprising" does not exclude other elements or steps, the term "a" or "an" does not exclude a plurality. Reference signs in the claims shall not be construed as limiting the scope of the claims.

Aspects of the present disclosure may relate to embodiments that are described by the following numbered clauses.

Clause 1. A system (100) for transporting an electronic component, comprising:
a carrier (220) for carrying the electronic component;
a transducer system (130) comprising a plurality of transducers (131), the transducer system being configured for generating a levitation field in which the carrier levitates;
an input unit (110) for arranging the electronic component onto the carrier;
an output unit (120) for receiving the electronic component from the carrier; and
a controller (140) for controlling the transducer system to change the levitation field for the purpose of moving the carrier from the input unit to the output unit;
wherein the carrier is optionally made from one or more of the materials out of the group consisting of polymers and/or low-density materials such as low-density metals, low-density composite materials, or low-density ceramics, the low-density materials preferably having a density less than 2000kg/m³.

Clause 2. The system according to clause 1, wherein the input unit further comprises a first dispensing unit (111) for dispensing a first attaching agent (111A) onto the carrier, said first attaching agent being configured to attach the electronic component to the carrier when receiving the electronic component, wherein the first attaching agent is optionally a liquid, such as water, wherein the output unit optionally comprises a detaching unit (121) for breaking the attachment of the electronic component to the carrier by the first attaching agent, wherein the first attaching agent optionally comprises a photo-absorbing material, and wherein the detaching unit comprises a light source (121) configured for illuminating the first attaching agent for the purpose of breaking said attachment by the first attaching agent, wherein the first attaching agent is preferably configured to evaporate as a result of illuminating the first attaching agent.

Clause 3. The system according to any of the previous clauses, wherein the output unit comprises a holding unit (240) for holding a substrate (241) on which the electronic component is to be arranged, wherein the output unit optionally comprises a second dispensing unit (122) for dispensing a second attaching agent (242) onto the substrate for the purpose of attaching the electronic component received from the carrier on the substrate.

Clause 4. The system according to any of the previous clauses, wherein the electronic component is a semiconductor die (230), wherein the input unit is configured for holding a wafer (230A) comprising a plurality of physically separated semiconductor dies, the input unit further comprising a releasing unit (112) for releasing a semiconductor die from the wafer causing and/or allowing the released semiconductor die to be arranged on the carrier;
wherein the physically separated semiconductor dies are optionally attached to a tape, foil, or film (231) using a third attaching agent (232, 232A), such as a photo-absorbing adhesive, wherein the releasing unit comprises a light source (112) for illuminating the third attaching agent (232A) for the purpose of breaking the attachment of a semiconductor die among the physically separated semiconductor dies to the tape, foil, or tape, by the third attaching agent;
wherein, relative to the Earth's gravitational field (F), the input unit is optionally arranged above the carrier at a time of arranging the electronic component on the carrier, wherein said input unit is configured to cause the electronic component to fall onto the carrier, and/or wherein, relative to the Earth's gravitational field, the output unit is optionally arranged below the carrier at a time of receiving the electronic component from the carrier, wherein said output unit is configured to cause the electronic component to fall from the carrier.

Clause 5. The system according to any of the previous clauses, wherein the plurality of transducers comprises a plurality of acoustic transducers (131) configured for generating soundwaves and wherein the levitation field is an acoustic levitation field, wherein the soundwaves generated by the plurality of acoustic transducers optionally have a frequency in a range between 20 kHz and 200 kHz, and/or wherein the transducers are optionally configured to generate an acoustic potential well in which the carrier and the component carried by the carrier can be trapped, and wherein the controller is configured for controlling the transducer system to change a position and/or orientation of the acoustic potential well for the purpose of moving the carrier.

Clause 6. The system according to clause 5, wherein the carrier has a first surface configured to support the electronic component, wherein a maximum thickness of the carrier in a direction perpendicular to the first surface is less than 1/3 times a wavelength of the soundwaves generated by the acoustic transducers;
wherein a surface area of the first surface is optionally at least 3 times greater than a maximum cross-sectional area of the electronic component, more preferably 10 times greater; and/or
wherein the acoustic potential well and/or the carrier is optionally elongated, wherein the first surface is optionally rectangular or oval.

Clause 7. The system according to any of the clauses 5-6, wherein the transducer system comprises one or more reflectors (R) for reflecting the soundwaves emitted by the transducers for the purpose of creating standing waves;
the system optionally comprising a housing (210) in which the acoustic field is generated, wherein the one or more reflectors are at least partially formed by an inner wall of the housing; and/or
wherein, in so far as depending on clause 4, the semiconductor wafer partially forms the one or more reflectors; and/or
wherein, in so far as depending on clause 3, the substrate and/or the holding unit holding the substrate optionally partially forms the one or more reflectors.

Clause 8. The system according to any of the previous clauses, wherein system comprises:
an input part (201) in which the input unit is arranged in combination with some of the plurality of transducers;
an output part (202) in which the output unit is arranged in combination with some of the plurality of transducers; and
a transfer part (203) arranged in between the input part and the output part in which some transducers of the plurality of transducers are arranged;
wherein said some of the plurality of transducers arranged in the transfer part are optionally configured for rotating and/or flipping the carrier while supporting the electronic component arranged thereon to cause the electronic component to face the output unit when the output unit receives the electronic component from the carrier.

Clause 9. The system according to any of the previous clauses, further comprising a localization system (150) for determining a position and/or orientation of the carrier and/or the electronic component carried by the carrier, wherein the controller is configured to control the transducer system in dependence of the determined position and/or orientation, wherein the localization system optionally comprises a vision system; and/or
wherein the localization system is optionally configured to determine the position and/or orientation of the carrier and/or the position and/or orientation of the electronic component carried by the carrier using echo-localization, wherein, in so far as depending on clause 5, the plurality of transducers is optionally further configured for generating soundwaves used for performing said echo-localization, said soundwaves having a different frequency when compared to the soundwaves for creating the levitation field.

Clause 10. The system according to any of the previous clauses, wherein the system is configured to transport a plurality of electronic components simultaneously, wherein, in so far as depending on clause 5, the transducer system is optionally configured to trap each of the plurality of electronic components that is to be transported simultaneously in a respective acoustic potential well.

Clause 11. The system according to any of the previous clauses, wherein the controller is configured for returning the carrier from the output unit to the input unit after having transported the electronic component for the purpose of transporting of an other electronic component.

Clause 12. A method for transporting an electronic component, comprising:
generating a levitation field in which a carrier is levitating;
arranging the electronic component onto the carrier while the carrier is levitating;
changing the levitation field for moving the carrier with the electronic component carried by the carrier; and
removing the electronic component from the carrier.

Clause 13. The method according to clause 12, wherein said levitation field is an acoustic levitation field, wherein the carrier and the electronic component carried by the carrier are optionally trapped in an acoustic potential well, and wherein said moving the carrier with the electronic component carried by the carrier comprises changing a position and/or orientation of the acoustic potential well.

Clause 14. The method according to any of the clauses 12-13, wherein the electronic component is a semiconductor die among a plurality of physically separated semiconductor dies comprised by a wafer, and wherein arranging the electronic component onto the carrier comprises releasing a semiconductor die from the wafer causing and/or allowing the released semiconductor die to be arranged on the carrier, wherein the physically separated semiconductor dies are optionally attached to a tape, foil, or film using a third attaching agent, such as an adhesive, wherein said releasing a semiconductor die comprises illuminating the third attaching agent for the purpose of breaking the attachment of a semiconductor die among the physically separated semiconductor dies by the third attaching agent;
wherein, in so far as depending on clause 13, wherein said generating a levitation field comprises using a plurality of transducers for generating soundwaves and allowing the soundwaves to be reflected by one or more reflectors for the purpose of creating standing waves, wherein the one or more reflectors are at least partially formed by the wafer.

Clause 15. The method according to any of the clauses 12-14, further comprising dispensing a first attaching agent on the carrier prior to arranging the electronic component on the carrier, said first attaching agent attaching the electronic component to the carrier, wherein said removing the electronic component optionally comprises breaking the attachment of the electronic component to the carrier by the first attaching agent, and wherein the first attaching agent optionally comprises a photo-absorbing material, and wherein said breaking the attachment comprises illuminating the first attaching agent using a light source; and/or
the method further comprising allowing a plurality of carriers and a corresponding plurality of electronic components carried by the carriers to simultaneously levitate in the levitating field, wherein, in so far as depending on clause 13, the carriers and corresponding electronic components are optionally trapped in respective acoustic cavities, the method further comprising simultaneously moving the carriers with the electronic components carried by the carriers by changing a position and/or orientation of the acoustic cavities.

## Claims

1. A system (100) for transferring an electronic component (230), comprising:
a carrier (220) having a first side;
a droplet dispensing unit (111) for dispensing a droplet of liquid (111A) on the first side of the carrier;
a separating unit (112) for releasing an electronic component from a donor substrate (230A) and for allowing the released electronic component to be held by the droplet on the first side of the carrier; and
an optical source (121) for emitting a pulse of light through the carrier towards an interface between the droplet and the carrier to locally vaporize the droplet thereby causing a jet to be formed from the droplet that on one end holds the electronic component and that subsequently breaks to thereby release the electronic component onto a target substrate (241).

2. The system according to claim 1, wherein the optical source is configured to emit the pulse of light such that the energy of the pulse of light is less than the energy to fully vaporize the droplet, preferably at least 10 times less, more preferably at least 50 times less.

3. The system according to any of the previous claims, wherein the liquid is water or a water-glycerol solution.

4. The system according to any of the previous claims, wherein the jet is formed in such a manner that its longitudinal axis extends from a first plane in a direction perpendicular to that plane;
wherein a spot (S) of the emitted pulse at or near the interface between the droplet and the carrier is equal to or smaller than a contact area (C) along the first plane across which the droplet contacts the carrier.

5. The system according to claim 4, wherein the carrier has a substantially flat shape, such as a disc or plate shape, wherein the first plane is parallel to and/or is defined by the first side of the carrier.

6. The system according to any of the previous claims, wherein the optical source is configured to emit a pulse that carries an energy that is higher than 0.03mJ per cm^2 of irradiated surface (E), more preferably higher than 4mJ per cm^2 of irradiated surface, wherein a pulse width of the emitted pulse is less than 200ns, more preferably less than 50ns, wherein the optical source preferably comprises a laser.

7. The system according to any of the previous claims, wherein the carrier is made of a material chosen from the group consisting of glass, quartz, and polymethyl methacrylate.

8. The system according to any of the claims 1-6, wherein the carrier comprises a carrier body (221A) and a coating (221B) arranged on the carrier body, wherein the coating at least partially forms the first side of the carrier, wherein the carrier is at least partially but preferably entirely transparent for the emitted pulse, and wherein the coating is at least partially but preferably entirely opaque for the emitted pulse;
wherein the carrier body is made of a material chosen from the group consisting of glass, quartz, and polymethyl methacrylate, and wherein the coating can be made of a material chosen from the group consisting of gold, silver, and titanium.

9. The system according to claim 8, wherein the coating is patterned in such a manner that the coating is present only at a position where it is to contact the droplet, wherein the coating is preferably in the form of a pad.

10. The system according to any of the previous claims, wherein the carrier comprises a focusing structure (222) for focusing the emitted pulse towards the interface between the carrier and the droplet, wherein the focusing structure preferably comprises a micro-lens provided on or formed in the carrier, or, in so far as depending on claim 8, the carrier body.

11. The system according to any of the previous claims, wherein the carrier comprises a recess (221C) or protrusion formed, at the first side, in the carrier or, in so far as depending on claim 8, the carrier body, wherein the recess or protrusion is configured to support the droplet.

12. The system according to any of the previous claims, wherein the droplet dispensing unit may be configured for arranging multiple droplets on the carrier, wherein the droplets are configured to each support a same electronic component, or wherein the droplets are configured to support multiple electronic components.

13. The system according to any of the previous claims, further comprising an optical splitter (123) that receives the emitted pulse from the optical source and that generates a plurality of sub-pulses (121A1, 121A2) that are each emitted towards a different droplet among the plurality of droplets.

14. The system according to any of the previous claims, further comprising:
a levitation system for levitating the carrier, wherein the levitation system preferably comprises a transducer system (130) comprising a plurality of transducers (131), the transducer system being configured for generating a levitation field in which the carrier levitates;
an input unit (110) for arranging the electronic component onto the carrier, wherein the input unit comprises the separating unit;
an output unit (120) for receiving the electronic component from the carrier, wherein the output unit comprises the optical source; and
a controller (140) for controlling the transducer system to change the levitation field for the purpose of moving the carrier from the input unit to the output unit.

15. A method for transferring an electronic component, comprising:
dispensing a droplet of liquid on a first side of a carrier;
releasing an electronic component from a donor substrate and allowing the released electronic component to be held by the droplet;
emitting a pulse of light through the carrier towards an interface between the droplet and the carrier to locally vaporize the droplet hereby causing a jet to be formed from the droplet that on one end holds the electronic component and that subsequently breaks to thereby release the electronic component onto a target substrate.
